**Europäisches Patentamt**

(19) **European Patent Office**

**Office européen des brevets**

(11) Publication number: **0 130 559**
**B1**

(12) **EUROPEAN PATENT SPECIFICATION**

(45) Date of publication of patent specification: **07.03.90**

(21) Application number: **84107449.5**

(22) Date of filing: **27.06.84**

(51) Int. Cl.⁵: **B 44 C 1/22,** G 03 F 7/26,
B 24 C 1/04

(54) **A method of producing a pattern-engraved article by sandblasting.**

(30) Priority: **28.06.83 JP 116497/83**

(43) Date of publication of application:
**09.01.85 Bulletin 85/02**

(45) Publication of the grant of the patent:
**07.03.90 Bulletin 90/10**

(84) Designated Contracting States:
**BE DE FR GB IT**

(56) References cited:
**EP-A-0 005 750**
**EP-A-0 042 562**
**EP-A-0 054 700**
**DE-A-1 281 899**
**GB-A-1 241 419**
**US-A-4 133 919**
**US-A-4 430 416**

(73) Proprietor: **Asahi Kasei Kogyo Kabushiki Kaisha**
**2-6, Dojimahama 1-chome Kita-ku**
**Osaka-shi Osaka 530 (JP)**

(72) Inventor: **Kobayashi, Hiroshi**
**11-21, Shoudo 5-chome Totsuka-ku**
**Yokohama-shi Kanagawa-ken (JP)**
Inventor: **Nakamura, Shohei**
**3675-16, Imaizumi**
**Fuji-shi Shizuoka-ken (JP)**

(74) Representative: **Schübel-Hopf, Ursula et al**
**Strehl Schübel-Hopf Groening Patentanwälte**
**Maximilianstrasse 54 Postfach 22 14 55**
**D-8000 München 22 (DE)**

Courier Press, Leamington Spa, England.

## Description

This invention relates to a method of producing a pattern-engraved article by sandblasting. More particularly, this inveniton is concerned with an inproved method of producing a pattern-engraved article by sandblasting in which a preliminary predetermined pattern layer constituted by vacant image portions and polymerisable composition image portions is formed on the surface of an article body and subjected to polymerization treatment, followed by sandblasting.

Conventionally, in order to engrave a desired pattern on the surface of an article made of glass, metal or the like, there has been proposed an etching process in which a coating of an anticorrosive material such as solid paraffin, asphalt, lacquer or the like is formed on the surface of an article made of glass, metal or the like and the coating is partially removed so that a desired pattern constituted by exposed surface portions of the article and unremoved coating portions is formed on the article and then the article is immersed in an etching solution for selectively dissolving the exposed portions of the article surface. Also, there has been proposed another etching process in which (1) a coating of a photosensitive material is formed on the surface of an article to be engraved, (2) the coating is exposed to actinic light through an image-bearing transparency such as positive and negative, (3) the unexposed portions of the coating are removed so that a desired pattern of the exposed coating portions is formed on the article and (4) the article is immersed in an etching solution. However, such processes are disadvantageous in that the preparation of an etching solution and the control of concentration of the etching solution are troublesome and that the used etching solution is required to be subjected to waste water treatment. Therefore, the etching processes are not suited for an industrial process for mass-production, Moreover, in the etching processes, the materials to be engraved are restricted to materials which are capable of being dissolved by some kinds of etching solutions.

To overcome the drawbacks accompanying the etching processes, various proposals have been made. For example, there has been proposed a method in which a rubber sheet is cut-out manually or by machine in accordance with desired letters or patterns and the obtained rubber sheet is attached onto an article to be engraved through the medium of an adhesive, followed by sandblasting (U.S. Patent No. 3,579,926). However, this method has such drawbacks that the rubber sheet must be prepared for each article to be engraved and must be attached to the surface of an article manually, causing the productivity to be lowered and that it is difficult to reproduce the same pattern with high accuracy.

In addition to the above method, there has also been proposed a method in which (1) a photopolymerizable composition layer provided on a support layer is exposed to actinic radiation through a negative bearing an image to convert the photopolymerizable composition layer to a polymeric image portions and non-polymeric portions, (2) the non-polymeric image portions of the layer is washed away, thereby to obtain a mask for sandblasting having letter images or patterns on the support layer, (3) the obtained mask is attached to the surface of the article through the medium of an adhesive or utilizing the adhesiveness of the polymeric image portions of the layer, (4) the support film is stripped off and (5) sandblasting is effected. This method is good in reproducibility and fineness of pattern and, therefore, is planned to be put to practical use (U.S. Patent No. 4,430,416). However, like the above-mentioned method in which a rubber sheet is used, the mask comprising a support film and the polymeric image portions provided thereon must be manually attached to the surface of an article. Thus, this method has such a drawback that the productivity is low.

There is also known a method in which (1) a thermoplastic resin dissolved in a solvent is printed onto the surface of an article of glass or ceramics by a screen printing technique, (2) the solvent is removed by heating so that the desired letters of patterns of the thermoplastic resin are formed on the surface, followed by sandblasting (Japanese Patent Application Laid-Open Specification No. 54-152294 and Japanese Patent Application Publication Specification No. 52-2831). However, this method has such disadvantages that the solvent is required to be evaporated by heating and, in heating, the article to be engraved itself will be heated, causing energy loss, that an apparatus for disposal of the solvent is needed, that the solvents usually employed tend to cause environmental pollution and that, during the screen process printing, spontaneous evaporation of the solvent occurs, causing the viscosity of the resin dissolved in a solvent to be changed so that printing cannot be performed uniformly.

Another process for producing an engraved pattern on the surface of an article by sandblasting is described in DE—B—1 281 899. According to this method the surface of the article is coated by several successive protective layers defining a pattern, which are produced by applying a polyvinylchloride plastisol, drying the plastisol coating and fusing the coating to the surface of the article by heating to a high temperature, after these process steps the coated article is subjected to sandblasting.

On the other hand, recently, engraved patterns having substantial beauty are desired more and more with the increase of high grade-indentation and personality-distinguishing indentation. As a method for producing a pattern-engraved article in which the engraved portions are varied with respect to depth and the engraved patterns have solid beauty, there has been proposed a method in which (i) a pattern-bearing film resistant to erosion by sandblasting is attached to the surface of an article, (ii) the article with the film is sandblasted to attain first engraving, (iii) a different pattern-bearing film is attached to the surface of the article, (iv) the article with the different pattern-bearing film is sandblasted and (v), according to need, such procedures are repeated. However, this method has the drawbacks that sandblasting must be effected a plurality of times and that pattern-bearing films must be attached to the surface of an article body manually.

Considering this state of the art, the present inventors have made intensive studies with a view to developing a method for producing a pattern-engraved article by sandblasting which not only has high productivity but also is good in reproducibility and which is free from the above problems. As a result, it has been found; that when a preliminary predetermined pattern layer constituted by vacant image portions and polymerizable composition image portions is formed on the surface of an article body by, for example, screen process printing and subjected to polymerization treatment, followed by sandblasting, pattern-engraved articles can be produced with high productivity and high reproducibility; and that when (1) a preliminary predetermined pattern layer constituted by vacant image portions and polymerisable composition image portions is formed on the surface of an article body by, for example, screen process printing, (2) the preliminary pattern layer on the article body is subjected to polymerization treatment to convert the polymerizable composition image portions to polymeric image portions, the steps (1) and (2), in combination, being performed a plurality of times, thereby to form on the surface of the article body a finished pattern layer which has a predetermined three dimensional pattern structure and which is constituted by the resulting vacant image portions and the resulting polymeric image portions having a thickness varied in accordance with the predetermined three dimensional pattern structure, and (3) an abrasive material is blown against the surface of the article body having the finished pattern layer to engrave not only surface portions of the article body corresponding to the resulting vacant image portions but also surface portions of the article body corresponding to the resulting polymeric image portions at their portions having a relatively small thickness, a pattern-engraved article whose engraved portions are varied with respect to depth and whose engraved pattern has solid beauty can be obtained easily.

Based on these novel findings, the present inventors have completed this invention.

It is, therefore, an object of the present invention to provide a method for producing a pattern-engraved article by sandblasting which is free from any of the above-described drawbacks experienced in the prior art.

This invention provides a method for producing a pattern-engraved article by sandblasting which comprises the steps of:
(1) image-wise applying a photopolymerizable composition onto the surface of an article body by a screen printing method to form a preliminary predetermined pattern layer constituted by vacant image portions and polymerizable composition image portions, said photopolymerizable composition comprising:
(a) a urethane prepolymer having acrylate groups or methacrylate groups,
(b) an ethylenically unsaturated monomer, and
(c) a photopolymerization initiator,
(2) subjecting the preliminary pattern layer on the article body to photopolymerization treatment to convert the polymerizable composition image portions to polymeric image portions having a Shore Durometer hardness A of 90 or less, a tensile strength of 4900 to 39200 kPa (50 to 400 kg/cm²), and an elongation of 30 to 400%;
the steps (1) and (2), in combination, being performed at least one time, thereby to form on the surface of the article body a finished pattern layer having a predetermined three dimensional pattern structure and constituted by the resulting vacant image portions and the resulting polymeric image portions;
(3) blowing an abrasive material against the article body on its surface having the finished pattern layer to engrave at least an image corresponding to said resulting vacant image portions of the finished pattern layer on the article body; and
(4) removing the remaining polymeric image portions from the finished pattern layer.

The features and advantages of the present invention will be apparent to those skilled in the art from the following detailed description and appended claims taken in connection with the accompanying drawings in which:

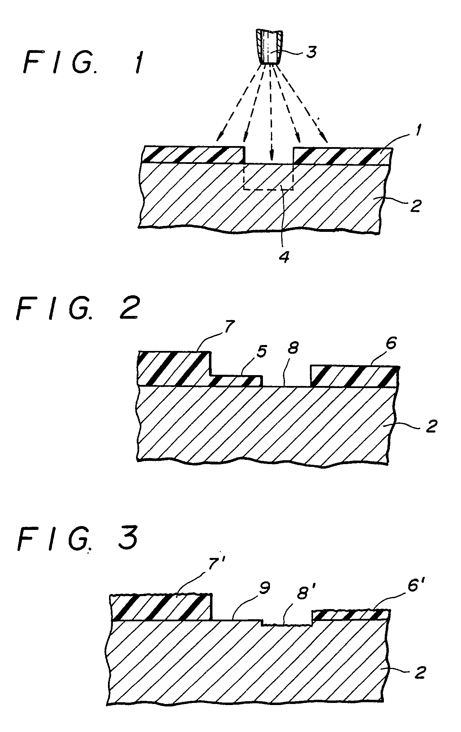

Fig. 1 is a schematic view illustrating the step of sandblasting in which an article having on its surface a finished pattern layer constituted by vacant image portions and polymeric image portions and having a thickness substantially equal with respect to all the polymeric image portions is sandblasted;

Fig. 2 is a fragmentary sectional view of an article which has on its surface a finished pattern layer having a predetermined three dimensional pattern structure and constituted by vacant image portions and polymeric image portions which have a thickness varied in accordance with the predetermined three dimensional pattern structure;

Fig. 3 is a fragmentary sectional view of a sandblasted article having on its surface a pattern layer which is obtained by blasting an abrasive material onto the surface of the article with the finished pattern layer shown in Fig. 2 to such an extent that the polymeric image portion 5 is just removed;

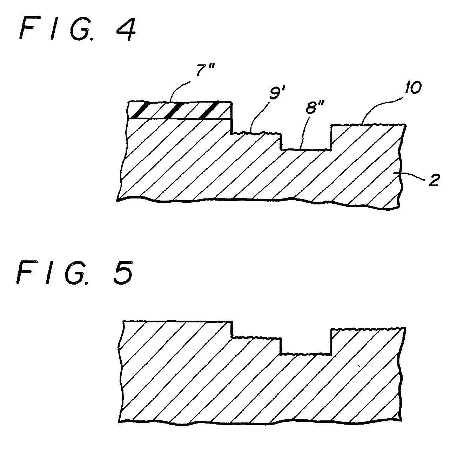

Fig. 4 is a fragmentary sectional view of a sandblasted article having on its surface a finished pattern layer which is obtained by further blasting an abrasive material onto the surface of the article with the finished pattern layer shown in Fig. 3; and

Fig. 5 is a fragmentary sectional view of a pattern-engraved article which is obtained by removing the remaining finished pattern layer from the surface of the article shown in Fig. 4.

In Fig. 1 and Figs. 2 to 5, like portions or parts are designated by like numerals.

Herein, the term "preliminary pattern layer" is intended to mean a pattern layer constituted by vacant image portions and polymerizable composition image portions. The term "finished pattern layer" is intended to mean a pattern layer constituted by vacant image portions and polymeric image portions.

The material of polymeric imagte portions of a finished pattern layer to be formed on the surface of an article body in the present invention is generally flexible and elastic and is not easily eroded by sandblasting so that at least a part of the polymeric image portions which is intended to be left unremoved remains on the surface of an article body and the desired engraving of the image on the article body can be attained by sandblasting. The preferable physical properties of such material are varied according to the conditions of sandblasting. However, the material preferably has a Shore Durometer hardness A of 90 or less as measured by a durometer. Moreover, with respect to the material of polymeric image portions of the pattern layer, the tensile strength as measured according to the method described later is 4900 KPa (50 kg/cm²) or more, preferably 4900 to 3924 KPa (50 to 400 kg/cm²) and the elongation as measured according to the method described later is 30% or more, preferably 30 to 400%. However, even if the Shore Durometer hardness A tensile strength and elongation of a material are outside the above ranges, as far as the material is resilient enough to resist erosion by sandblasting, such a material may be used.

As the polymerizable composition capable of being converted to the material having the above-mentioned physical properties, there may be mentioned various kinds of compositions. Such compositions, include the following composition.

(1) a photopolymerizable composition comprising as polymerizable components (i) a urethane prepolymer having acrylate groups or methacrylate groups and (ii) an ethylenically unsaturated monomer, and (iii) a photopolymerization initiator.

With respect to the above photopolymerizable composition (1), an illustrative explanation will be given below.

The urethane prepolymer having acrylate groups or methacrylate groups can be produced by reacting a reactant having hydroxyl groups such as a polyether having at its both ends hydroxyl groups, a polyester having at its both ends hydroxyl groups, a block copolymer of a polyether and a polyester having at its both ends hydroxyl groups, a polyolefin having at its both ends hydroxyl groups and a polydiene having at its both ends hydroxyl groups with a diisocyanate to form a urethane prepolymer having at its both ends isocyanate groups and reacting the resulting urethane prepolymer with a hydroxyalkyl ester of acrylic acid or methacrylic acid. Specific examples of the polyether having at its both ends hydroxyl groups are a polyethylene glycol, polypropylene glycol, copolymer of ethylene oxide—propylene oxide and polytetramethylene glycol. Specific examples of the polyester having at it both ends hydroxyl groups are polyethylene glycol adipate diol and polycaprolactone diol. Specific examples of the block copolymer of a polyether and a polyester having at its both ends hydroxy groups are a block copolymer of polyethylene glycol and polyethylene glycol adipate diol, block copolymer of polyethylene glycol and polycaprolactone diol, block copolymer of polypropylene glycol and polyethylene glycol adipate diol, block copolymer of polypropylene glycol and polycaprolactone diol, block copolymer of polytetramethylene glycol and polyethylene glycol adipate diol and block copolymer of polytetramethylene glycol and polycaprolactone diol. As the specific examples of the polyolefin having hydroxyl groups, there may be mentioned hydrogenated polybutadiene and the like. As the specific examples of the polydiene, there may be mentioned polybutadiene diol and the like. Specific examples of the diisocyanate to be used in the above reaction are 2,6-tolylene diisocyanate, diphenylenemethane diisocyanate, hexamethylene diisocyanate and the like. As the hydroxyalkyl ester of acrylic acid or methacrylic acid, there may be mentioned 2-hydroxymethyl methacrylate, 2-hdyroxypropyl methacrylate, polypropylene glycol monomethacrylate, polyethylene glycol monomethacrylate, 2-hydroxyethyl acrylate, 2-hydroxypropyl acrylate, polypropylene glycol monoacrylate, polyethylene glycol monoacrylate and the like.

As the ethylenically unsaturated monomer to be used in combination with the urethane prepolymer, there may be mentioned, for example, acrylic acid, methacrylic acid, esters of acrylic acid or methacrylic acid such as an alkyl acrylate, cycloalkyl acrylate, tetrahydrofurfuryl acrylate, allyl acrylate, glycidyl acrylate, hydroxyalkyl acrylate, alkyl methacrylate, cycloalkyl methacrylate, tetrahydrofurfuryl methacrylate, allyl methacrylate, glycidyl methacrylate, hydroxyalkyl methacrylate, alkylene glycol monoacrylate, alkylene glycol diacrylate, alkylene glycol monomethacrylate, alkylene glycol dimethacrylate, polyalkylene glycol monoacrylate, polyalkylene glycol diacrylate, polyalkylene glycol monomethacrylate, polyalkylene glycol dimethacrylate, pentaerythritol tetraacrylate, pentaerythritol tetramethacrylate; acrylamide, methacrylamide and derivatives thereof such as N-methylolacrylamide, N-methylolmethacrylamide, N,N'-alkylenebisacrylamide, N,N'-alkylenebismethacrylamide, diacetone acrylamide, diacetone methacrylamide; and unsaturated monomers capable of being addition polymerized such as styrene, vinyltoluene, divinylbenzene, diallyl phthalate, triallyl cyanurate, vinyl acetate, acrylonitrile and the like.

As the photopolymerization initiator, there may be employed benzophenone, acetophenone, acenaphthenequinone, p,p'-dimethylaminobenzophenone, benzoin, benzoin ethyl ether, benzoin isopropyl ether, benzyldimethylketal (2,2-dimethoxyphenylacetophenone), 2-ethylanthraquinone, 1-chloroanthraquinone, 1-chlorothioxanthone, 2-methylthioxanthone and the like.

The weight proportions of the urethane prepolymer and the ethylenically unsaturated monomer relative to the total of the urethane prepolymer and the ethylenically unsaturated monomer is 20 to 80% and 80 to 20%, respectively. It is preferred that the weight proportions of the urethane prepolymer and the ethylenically unsaturated monomer relative to the total of the urethane prepolymer and the ethylenically unsaturated monomer be 40 to 60% and 60 to 40%, respectively. The weight proportion of the photopolymerization initiator relative to the total of the polymerizable components, that is, the urethane prepolymer and ethylenically unsaturated monomer is 0.5 to 10%.

In order to increase the storage stability of photopolymerizable compositions, a heat polymerization inhibitor is preferably incorporated. As the heat polymerization inhibitor to be used in the present invention, there may be mentioned hydroquinone, p-methoxyphenol, catechol, tert-butyl hydroquinone, benzoquinone, p-phenylenediamine, picric acid, phenothiazine, 2,6-di-tert-butyl-p-cresol and the like. The weight proportion of the heat polymerization inhibitor relative to the total of the polymerizable components in each composition is 0.001 to 1%.

In the present invention, when bubbles are present in the photopolymerizable compositions, polymerization reaction is suppressed due to oxygen in the bubbles and the photopolymerizable compositions are polymerized with the bubbles being contained in the composition, leading to lowering of the mechanical strength of the polymerized substance so that the resistance to erosion by sandblasting is lost. For this reason, it is preferred to incorporate an anti-foam agent in the present invention. The anti-foam agent to be used in the present invention may be freely chosen from the known anti-foam agents such as silicone type anti-foam agents, vinyl compound polymer type anti-foam agents, silicone/vinyl compound polymer type anti-foam agents, mineral/nonionic surface active agent type anti-foam agents. As the silicone type anti-foam agent, there may be mentioned, for example, Silicone KP-330, Silicone KP-331 and Silicone KS-607 (each, trademark of a silicone type anti-foam agent manufactured and sold by Shin-Etsu Chemical Co., Ltd., Japan). as the vinyl compound polymer type anti-foam agent, there may be mentioned, for example, Disparlon # 1970, Disparlon # 1950, Disparlon OX-70, Disparlon OX-880 and Disparlon OX-88M (each, trademark of an anti-foam agent manufactured and sold by Kusumoto Chemical Ltd., Japan). As the silicone/vinyl compound polymer type anti-foam agent, there may be mentioned, for example, Disparlon # 1930, Disparlon # 1931 and Disparlon # 1933 (each, trademark of an anti-foam agent manufactured and sold by Kusumoto Chemicals Ltd., Japan). As the mineral/nonionic surface active agent anti-foam agent, there may be mentioned, for example, SN-DEFOAMER-113, SN-DEFOAMER-149, SN-DEFOAMER-157 and SN-DEFOAMER-247 (each, trademark of an anti-foam agent manufactured and sold by San Nopco Limited, Japan).

The weight proportion of the anti-foam agent relative to the total of polymerizable components in each composition is 0.2 to 5%, preferably 0.5 to 2%.

In order to lower the surface tension of the photopolymerizable composition so that application of the photopolymerizable composition onto the surface of an article body is easily effected and uniform thickness is attained, it is preferred that a leveling agent be added to the photopolymerizable composition. As the leveling agent, there may be employed known modified silicone type leveling agents and the like. As the leveling agent to be used in the present invention, there may be mentioned Disparlon # 1710, Disparlon # 1750, Disparlon # 1760 and Disparlon # 1970 (each, trademark of a leveling agent manufactured and sold by Kusumoto Chemicals Ltd., Japan). The weight proportion of the leveling agent relative to the total of the polymerizable components in each composition is 0.2 to 5%, preferably 0.5 to 2%.

Some of the above-mentioned anti-foam agents and leveling agents have both anti-foam and leveling properties. Therefore, in some cases, even when either an anti-foam agent or a leveling agent as an additive is incorporated, both the desired anti-foaming and leveling effects are attained. In such cases, the weight proportion of the additive relative to the polymerizable components in each photopolymerizable composition is 0.2 to 5%, preferably 0.5 to 2%.

When the weight proportion of the additive such as an anti-foam agent and a leveling agent relative to the total of the polymerizable components in each composition is less than 0.2%, satisfactory anti-foaming effect and/or leveling effect is not attained. On the other hand, when the weight proportion of the additive relative to the total of the polymerizable components in each composition is more than 5%, the anti-foaming effect and/or leveling effect is not improved, while causing economic disadvantages.

In addition to the anti-foam agent and/or the leveling agent, according to need, an extender pigment may be incorporated into the photopolymerizable composition and a color pigment may also be incorporated into the photopolymerizable composition. As the extender pigment, there may be employed, for example, silica, alumina, clay, talc, calcium carbonate, barium sulfate and the like. As the color pigment, there may be employed mineral pigments such as titanium dioxide, prussian blue, blood red and organic pigments such as phthalocyanine type organic pigments. The weight proportions of the extender pigment and the color pigment relative to the total of the polymerizable components in each polymerizable composition are 20% or less and 1% or less, respectively.

In the present invention, when the viscosity of the photopolymerizable composition is less than 5 Pa.s (50 poises (P)) at 25°C, sagging or running of patterns tends to occur, leading to lowering of accuracy of the pattern. In order to avoid such disadvantage, an organic thickening agent or high polymer which is soluble in the composition may be added prior to application of the composition so that the viscosity of the photopolymerizable composition is adjusted. As the organic thickening agent or high polymer, there may be used a phenolic resin, alkyd resin, petroleum resin, cyclized rubber, polyamide resin, acrylic resin, nitrocellulose, polyvinyl acetate, polyvinyl butyral and natural resins such as rosin, shellac, copal, gilsonite and casein. The weight proportion of the organic thickening agent or high polymer relative to the total of the polymerizable components in each composition is preferably 10% or less.

Next, with respect to the method of applying the photopolymerizable composition onto the surface of an article body, there may be employed various methods, for example, such as a screen process printing method, gravure printing method and spraying method in which stencils are used.

Where the screen process printing method is employed, it is preferred that the photopolymerizable composition be adjusted to have a viscosity of 5 to 200 Pa.s (50 to 2000 P) (at 25°C) as measured according to the method described later. As the screen to be used in this method, there may be mentioned a stainless steel screen, a polyester screen, a silk screen, a nylon screen and the like. In this method, generally, screens having 50 to 500 meshes per 2.54 cm (50 to 500 mesh (Tyler)) are used. The polymerizable compositions to be used in the screen process printing are required to have such characteristics that the polymerizable compositions pass through the mesh of the screen to be used, that after the composition passed through the mesh of the screen, the polymerizable composition film is leveled so that the pattern of the mesh of the screen does not remain on the polymerizable composition film and that the polymerizable composition does not run on the article body, that is, the polymerizable composition has a thixotropic characteristic or a viscosity more than 1 Pa.s (10 P), preferably 5 Pa.s (50 P) or more at 25°C.

As the photosensitive emulsion to be used for preparing a screen bearing an image, there may be used customarily employed a bichromate emulsion, a diazo type emulsion and emulsions utilizing other photosensitive compounds. The emulsion thickness of a screen is generally in the range of 5 to 100 μm. However, according to need, a screen having an emulsion thickness more than 100 μm may be used. For preparing a screen bearing an image, not only a photomechanical process but also manual methods such as cutting may be used.

In the case of the gravure printing method, it is preferred that the photopolymerizable composition be adjusted to have a viscosity of 5 to 50 Pa.s (50 to 300 P) (at 25°C) as measured according to the method described later. The application of the photopolymerizable composition may be carried out in accordance with the customary gravure printing method.

In the case of the spraying method in which stencils are used, it is preferred that the photopolymerizable composition be adjusted to have a viscosity of 5 to 20 Pa.s (50 to 200 P) (at 25°C) as measured according to the method described later. As the stencil to be used in this method, there may be employed paper stencils, plastic stencils, metal stencils such as steel stencils, aluminum stencils and copper stencils.

With respect to the viscosity of the photopolymerizable composition, when the viscosity is less than 5 Pa.s (50 P) at 25°C, as described before, sagging or running of patterns tends to occur at the time of application of the composition, leading to lowering of accuracy of the pattern. On the other hand, when the viscosity is more than the respective upper limit values in the above-described methods, the printing speed is decreased and it becomes difficult to reproduce fine patterns. In the case of the spraying method, even when the viscosity of the photopolymerizable composition is more than the above-mentioned upper limit value, the photopolymerizable composition may be used if the composition is heated to adjust the viscosity of the composition to the above-mentioned range at the time of application. Generally, the application of the photopolymerizable composition is carried out at 5 to 35°C but not limited to this temperature range.

Of the above-described application methods, the screen process printing is most preferred. The screen process printing has advantages that a fine pattern is easily obtained, that polymerizable compositions can be applied to not only sheet articles but also curved articles and that the working environment is not polluted.

Now, one embodiment of the present invention will be illustrated. A polymerizable composition is imagewise applied onto the surface of an article body to form a preliminary predetermined pattern layer constituted by vacant image portions and polymerizable composition image portions and the preliminary pattern layer is subjected to polymerization treatment. In this way, there is obtained a finished pattern layer constituted by vacant image portions and polymeric image portions and having a desired thickness substantially equal with respect to all the polymeric image portions. The application of a polymerizable composition in the above-mentioned step (1) may usually be performed by conducting, for example, screen process printing operation, gravure printing operation and spraying operation one time, but may occasionally be performed by conducting the above-mentioned printing operation two or more times. If the desired thickness of the polymeric image portions of the finished pattern layer is not obtained by performing a sequence of the application of a polymerizable composition [step (1)] and the polymerization treatment [step (2)] only one time, such sequence may be repeated at least one time until the desired thickness of a finished pattern layer is obtained.

The thickness of polymeric image portions of the finished pattern layer may generally be 30 to 600 μm. However, as described later, when an engraved pattern of which the engraved portions have a depth varied in accordance with the predetermined three dimentional pattern is obtained, the thickness of polymeric image portions of the finished pattern layer may be less than 30 μm.

Generally, the thickness of polymeric image portions of the finished pattern layer is adjusted taking into consideration the hardness of polymeric image portions of the finished pattern layer, the kind of materials of the article body to be engraved, the desired depth of the engraved portions, the kind of abrasive material to be used in sandblasting. The adjustment of the thickness of a finished pattern layer may be effected by, as described above, repeating a sequence of the application of a polymerizable composition and the polymerization treatment or by, for example, changing the kind of screen, the emulsion thickness of screen, the thickness of stencil and the like.

When a photopolymerizable composition is used as the polymerizable composition, the polymerization treatment to convert the polymerizable composition image portions to polymeric image portions is effected by exposing the polymerizable composition image portions to actinic radiation. The sources of actinic radiation for exposure to be used in the present invention are, for example, high pressure mercury lamps, metal halide high pressure mercury lamps, super high pressure mercury lamps, high pressure xenon lamps, xenon arc lamps, which contain ultraviolet radiation preferably having a wavelength of 300—420 nm.

After the polymerization treatment, an abrasive material is blown onto the surface of an article body with a finished pattern layer constituted by the resulting vacant image portions and the resulting polymeric image portions. The blowing of an abrasive material is performed through the resulting vacant image portions against the article body to engrave an image corresponding to that of the resulting image portions on the article body.

In Fig. 1, there is illustrated the step of sandblasting in which an abrasive material is blown from a nozzle 3 onto the surface of an article body 2 having on its surface a finished pattern layer constituted by a vacant image portion and polymeric image portions 1 and having a thickness substantially equal with respect to all the polymeric image portions.

As the abrasive material, there may be employed natural abrasive materials such as quartz sand and garnet, artificial abrasive materials such as silicon carbide, molten alumina, nitrogen carbide and synthetic diamond and metal abrasive materials such as pig iron shot, steel grains. When the article body to be engraved is relatively soft, glass beads, plastic beads, walnut shell flour and the like may be used. It is preferred that the above-mentioned abrasive materials have a particle diameter of 30 to 500 μm.

The above-mentioned abrasive materials are carried by high pressure air or high pressure liquid and blown onto the surface of an article body. The blowing pressure is usually in the range of 2 to 6 bar (kg/cm$^2$). The sandblasting is usually effected to an extent that the depth of engraved portions is 10 to 100 μm. According to need, the sandblasting may be effected to attain further deep engraving.

After completion of the sandblasting operation, the remaining polymeric image portions of the finished pattern layer are removed. The removal of the remaining polymeric image portions may be effected mechanically by means of an abrasing machine or brush. The remaining polymeric image portions may also be removed by dissolving or swelling the polymeric image portions using a suitable solvent. As the suitable solvent, there may be mentioned 1,1,1-trichloroethane, methylene chloride, alkaline aqueous solutions such as an aqueous NaOH solution and acidic aqueous solutions. The above mechanical removal procedure may be employed in combination with the procedure in which a suitable solvent is used. Where an article body is made or a non-combustible material such as glass, ceramic and stone, the removal of the remaining polymeric image portions may be carried out using plasma.

A pattern-engraved article which is obtained in the above-described manner can, as such, be put to practical use. In the method of the present invention, however, according to need, chemical treatment may be performed before or after removing the remaining polymeric image portions. Illustratively stated, when a glass article is used, treatment with, for example, a mixture of hydrofluoric acid and concentrated sulfuric acid may be effected before or after removing the remaining polymeric image portions to corrode the surface portions of the article which are not covered with the remaining polymeric image portions or to corrode the entire surface of the article, thereby to modify the condition of the surface of the article. When formation of a printed circuit on a copper-clad board by the method of the present invention is intended, treatment with an acidic aqueous solution of copper (II) chloride or iron (II) chloride may be effected before removing the remaining polymeric image portions to dissolve the copper remaining unremoved in the predetermined exposed pattern portions to be engraved by sandblasting, so that there can be obtained a clean printed circuit according to a predetermined circuit pattern.

According to the method of the present invention, the desired patterns or letters can be readily, simply engraved on the surfaces of wood articles, ceramic articles, glass articles, metal articles, synthetic resin articles and the like. Further, since solvents causing environmental pollution are not used in the present invention, the method of the present invention is suitable for producing a pattern-engraved article by sandblasting on an industrial scale.

When a photopolymerizable composition is used as the polymerizable composition, the polymerizable composition image portions of a preliminary predetermined pattern layer can be converted to polymeric image portions by actinic radiation exposure in a short period of time and, according to need, the sequence of the application of a photopolymerizable composition and the polymerization treatment may be easily repeated.

According to another embodiment of the present invention, there is provided a method of producing a pattern-engraved article by sandblasting which comprises the steps of:

(1) image-wise applying a polymerizable composition onto the surface of an article body to form a predetermined preliminary pattern layer constituted by vacant image portions and polymerizable composition image portions:

(2) subjecting the preliminary pattern layer on the article body to polymerization treatment to convert the polymerizable composition image portions to polymeric image portions;

the steps (1) and (2), in combination, being performed a plurality of times, thereby to form on the surface of the article body a finished pattern layer having a predetermined three dimensional pattern structure and constituted by the resulting vacant image portions and the resulting polymeric image portions so that the resulting polymeric image portions of the finished pattern layer have a thickness varied in accordance with the predetermined three dimensional pattern structure;

(3) blowing an abrasive material against the article body on its surface having the finished pattern layer so that not only surface portions of the article body corresponding to said resulting vacant image portions but also surface portions of the article body corresponding to said resulting polymeric image portions at their portions having a relatively small thickness are engraved to form on the article body an engraved pattern of which the engraved portions have a depth varied in accordance with the predetermined three dimensional pattern structure; and

(4) removing the remaining polymeric image portions of the finished pattern layer.

The polymeric image portions obtained by at least one sequence of said steps (1) and (2) may be at least partially different in pattern from those obtained by the preceding and/or subsequent sequence of said steps (1) and (2).

Figs. 2 to 5 illustrate in a stepwise manner how to obtain an engraved pattern of which the engraved portions have a depth varied in accordance with a predetermined three dimensional pattern. A polymerizable composition is applied onto the surface of an article body 2 to form a preliminary predetermined pattern layer constituted by vacant image portions and polymerizable composition image portions and the preliminary pattern layer is subjected to polymerization treatment. The application of a polymerizable composition in the above-mentioned step (1) may usually be performed by conducting, for example, a screen process printing operation, gravure printing operation and spraying operation one time, but may occasionally be performed by conducting the above-mentioned printing operation two or more times. The sequence of the application of a polymerizable composition and the polymerization treatment is performed a plurality of times. The mode for performing a plurality of sequences of steps (1) and (2) is not critical insofar as the resulting polymeric image portions of the finished pattern layer have a thickness varied in accordance with the predetermined three dimensional pattern structure. The varied thicknesses of the resulting polymeric image portions of the finished pattern may be obtained by, for example, varying the number of times of sequences of the combination of steps (1) and (2) at different areas in accordance with the predetermined three dimensional pattern structure, or by changing the kind of screen or the emulsion thickness of the screen every sequence and performing a respective sequence of the combination of steps (1) and (2) so that a polymeric image having a different thickness is formed at a different area. In this way, there may be easily formed on the surface of the article body 2 a finished pattern layer constituted by a vacant image portion and three polymeric image portions different in thickness, that is, a polymeric image portion 5 having the smallest thickness, a polymeric image portion 6 having a thickness larger than that of the polymeric image portion 5 and a polymeric image portion 7 having the largest thickness (see Fig. 2). The portion 8 of the surface of the article body 2 is left exposed to constitute the vacant portion. Thus, there is provided a predetermined three dimensional pattern layer structure on the article body 2. When an abrasive material is blown onto the surface of the article body over the finished pattern layer formed thereon until the polymeric image portion 5 is just removed, the surface portion 9 corresponding to the polymeric image portion 5 is exposed and the surface portion 8 is engraved to form an engraved portion 8' while the polymeric image portions 6 and 7 are partially removed to form polymeric image portions 6' and 7' which are reduced in height (see Fig. 3).

When the blowing of an abrasive material onto the surface of the article body is continued, the engraved portion 8' is further engraved to obtain an engraved portion 8'' and, at the same time, the surface portion 9 is engraved to give an engraved portion 9'. Simultaneously, the partially removed polymeric image portion 6' is completely removed and, in turn, the resulting exposed surface portion 10 is coarsened while the partially removed polymeric image portion 7' is further partially removed but still remains as a polymeric image portion 7'' (see Fig. 4). Next, the remaining image portion 7'' as shown in Fig. 4 is removed in substantially the same manner as described with respect to the preceding embodiment, thus providing a pattern-engraved article bearing an engraved pattern of which the engraved portions have varied depths (see Fig. 5).

As described above, in the present embodiment, not only surface portions of the article body corresponding to the vacant image portions but also surface portions of the article body corresponding to the polymeric image portions at their portions having a relatively small thickness can be engraved. The surface portions of the article body corresponding to the polymeric image portions at their portions having a relatively small thickness are engraved by sandblasting only after the polymeric portions having a relatively small thickness are completely removed by sandblasting and, therefore, the depths of the engraved surface portions corresponding to the polymeric image portions are smaller than that of the engraved surface portions of the article body corresponding to the vacant image portions. On the other hand, surface portions of the article body corresponding to the polymeric image portions at their portions having a relatively large thickness are not engraved by sandblasting. Thus, there is obtained a pattern-engraved article bearing an engraved pattern of which the engraved portions have a depth varied in accordance with the predetermined three dimensional pattern structure of the finished pattern layer constituted by the vacant image portion 8 and the polymeric image portions 5, 6, and 7.

The period of time in which the polymeric image portions of the finished pattern layer are removed by sandblasting depends on the kind of polymerizable composition to be used, thickness of polymeric image portions and conditions of sandblasting including the kind of abrasive material. Therefore, prior to practice, it is necessary to conduct a test experiment in which a finished pattern layer of which the polymeric image portions have a thickness varied in accordance with the predetermined three dimensional pattern is formed on the surface of an article body and sandblasting is effected under predetermined conditions to determine a period of time in which the desired engraved pattern is obtained on the article body while removing the polymeric image portions having a relatively small thickness. Thus, an article having the desired engraved pattern of which the engraved portions have a depth in accordance with the predetermined three dimensional pattern can be easily, simply produced on an industrial scale.

In this embodiment, the thickness of the polymeric image portions of the finished pattern layer may generally be in the range of 10 to 600

μm and the thickness of the polymeric image portions to be removed by sandblasting may be 100 μm or less, preferably 10 to 50 μm. However, with respect to the polymeric image portions to be removed, if the sandblasting conditions are appropriately chosen, even the polymeric image portions having a thickness more than 100 μm can be removed by sandblasting.

In accordance with this embodiment of the present invention, there is obtained a three dimensional pattern-engraved article of which the engraved portions are varied with respect to depth. Further, it should be noted that by this embodiment in which there is formed on an article body a finished pattern layer of which the polymeric image portions have a thickness varied in accordance with the three dimensional predetermined pattern structure and sandblasting is effected, the desired three dimensional pattern-engraved article can be easily, simply obtained by effecting sandblasting only once as different from the conventional method in which there are involved complicated procedures, that is, (i) a pattern-bearing film resistance to erosion by sandblasting is attached to the surface of an article, (ii) the article with the film is sandblasted to attain first engraving, (iii) a different pattern-bearing film is attached to the surface of the article, (iv) the article with the different pattern-bearing film is sandblasted and (v), according to need, such procedures are repeated.

In still another embodiment of the present invention, there is provided a method of producing a pattern-engraved article by sandblasting which comprises the steps of:

(1) image-wise applying a polymerizable composition onto the surface of an article body to form a preliminary predetermined pattern layer constituted by vacant image portions and polymerizable composition image portions so that the polymerizable composition image portions of said preliminary pattern layer have a thickness varied in accordance with a preliminary predetermined three dimensional pattern;

(2) subjecting the preliminary pattern layer on the article body to polymerization treatment to convert the polymerizable composition image portions to polymeric image portions;

the steps (1) and (2), in combination, being performed at least one time, thereby to form on the surface of the article body a finished pattern layer having a predetermined three dimensional pattern structure and constituted by the resulting vacant image portions and the resulting polymeric image portions;

(3) blowing an abrasive material against the article body on its surface having the finished pattern layer so that not only surface portions of the article body corresponding to said resulting vacant image portions but also surface portions of the article body corresponding to said resulting polymeric image portions at their portions having a relatively small thickness are engraved to form on the article body an engraved pattern of which the engraved portions have a depth varied in accordance with the predetermined three dimensional pattern structure; and

(4) removing the remaining polymeric image portions of the finished pattern layer.

The image-wise application of a polymerizable composition in the above-mentioned step (1) may be performed by conducting, for example, a screen process printing operation, gravure printing operation and spraying operation one or more times to form a preliminary predetermined pattern layer. For example, when the screen process printing is employed, two or more kinds of screens may usually be utilized to form the preliminary pattern layer constituted by vacant image portions and polymerizable composition image portions and having a thickness varied in accordance with a preliminary predetermined three dimensional pattern. In this case, the application of a composition is separately conducted necessary times in accordance with the number of screens. It should be noted that even by the one-time use of only one kind of screen, it is possible to form the desired preliminary pattern layer by a process in which a screen is placed on the surface of an article body and polymerizable compositions different in viscosity are then applied to different portions of the screen.

The preliminary predetermined three dimensional pattern may be substantially the same as the predetermined three dimensional pattern of the finished pattern layer. In this case, the application of a polymerizable composition [step (1)] and the polymerization treatment [step (2)], in combination, may be conducted only one time.

On the other hand, the preliminary predetermined three dimensional pattern may be at least partially different from the predetermined three dimensional pattern of the finished pattern layer. In such case, the application of a polymerizable composition [step (1)] and the polymerization treatment [step (2)], in combination, may be conducted a plurality of times.

The blowing of an abrasive material against the article body in this embodiment can be performed in substantially the same manner as described in connection with the preceding embodiment in which the blowing of an abrasive material is performed so that not only surface portions of the article body corresponding to said resulting vacant portions but also surface portions of the article body corresponding to said resulting polymeric image portions at their portions having a relatively small thickness are engraved to form on the article body an engraved pattern of which the engraved portions have a depth varied in accordance with the predetermined three dimensional pattern structure.

The removal of the remaining polymeric image portions can be performed in substantially the same manner as described before.

The present invention will be illustrated in more detail with reference to the following Examples, which should not be construed to be limiting the scope of the present invention.

In the following Examples, the viscosity, Shore Durometer hardness A tensile strength and elongation were measured in accordance with the following methods.

(1) Measurement of the viscosity

The viscosity of photopolymerizable compositions is measured at 25°C by means of B8H type Brookfield rotational viscometer (tradename of a Brookfield rotational viscometer manufactured and sold by Tokyo Kieki Co., Ltd., Japan).

(2) Measurement of the Shore Durometer hardness A

a) The photopolymerizable composition in each Example is applied to the surface of a glass plate treated with a silicone type lubricant to obtain a layer of 100 μm thickness and subjected to photopolymerization treatment under the same conditions as employed in each Example. The obtained photopolymerized layer is stripped from the glass plate to obtain a sheet.

b) The obtained sheet is cut off into 20 mm×40 mm test pieces and 30 test pieces or more are laminated to obtain a sample sheet having a thickness of 3 mm or more.

c) The Shore Durometer hardness A of the sample sheet is measured at 20°C using a spring type Shore Durometer (A type).

(3) Measurement of the tensile strength and the elongation at break

a) The photopolymerizable composition in each Example is applied to the surface of a glass plate treated with a silicone type lubricant to obtain a layer of 100 μm thickness and subjected to photopolymerization treatment under the same conditions as employed in each Example. The obtained photopolymerized layer is stripped from the glass plate to obtain a sheet.

b) The obtained sheet is die-cut by means of a Schopper type punching machine to obtain a JIS No. 1 dumbbell test piece (JIS: Japanese Industrial Standards). A dumbbell test piece is stretched at 20°C at a rate of 50 mm/min using Autograph P-100 (a tensile strength tester manufactured and sold by Shimadzu Corporation, Japan) until it breaks. From the stress at break, the tensile strength is calculated. From the increment, at break, of the length of the test piece, the elongation (%) at break is calculated.

Example 1

100 Parts by weight of liquid polybutadiene (number average molecular weight: about 1500) having hydroxyl groups at both ends thereof was mixed with 13 parts by weight of tolylene diisocyanate (a mixture of 80% by weight of 2,4-isomer and 20% by weight of 2,6-isomer) and 0.25 part by weight of dibutyltin dilaurate, and reaction was effected at 70°C for 2 hours to form a urethane prepolymer having isocyanate groups at both ends thereof. Then, 10 parts by weight of 2-hydroxyethyl methacrylate and 0.025 part of weight of 2,6-di-tert-butyl-p-cresol were added to the thus obtained urethane prepolymer, and reaction was effected at 70°C for 2 hours to obtain an unsaturated urethane prepolymer.

100 Parts by weight of the thus obtained unsaturated urethane prepolymer was mixed with 35 parts by weight of lauryl methacrylate, 3.0 parts by weight of 2,2-dimethoxyphenyl acetophenone, 0.5 part by weight of Silicone KP-324 (trademark of a silicone type anti-foam agent manufactured and sold by Shin-Etsu Chemical Co., Ltd., Japan) and 0.5 part by weight of phthalocyanine green to obtain a photopolymerizable composition having a viscoisty of 20 Pa.s (200 P) (as measured at 25°C).

The thus obtained photopolymerizable composition was applied to a glass plate (20 cm×30 cm×10 mm) at room temperature using a stainless steel screen bearing an image and having an emulsion thickness of 20 µm, which screen had been prepared by applying a diazo-type photosensitive emulsion comprising a diazo resin and a polyvinyl alcohol to a stainless steel screen having 200 meshes per 2.54 cm (200 mesh, Tyler) and subjected to image-forming treatment by photomechanical technique. As a result, a pattern layer of the photopolymerizable composition corresponding to the image borne by the screen and having a thickness of 100 µm was formed on the glass plate. The pattern-formed glass plate was passed at a rate of 4 m/min under an actinic radiation device having three metal halide high pressure mercury lamps (each 120 W/cm) by means of a conveyor placed at a distance of 1 m from the device so that the photopolymerizable composition pattern layer-formed glass plate was exposed to actinic radiation for photopolymerization.

Subsequently, the thus obtained pattern-formed glass plate was sandblasted by means of a siphon-type sandblaster (manufactured and sold by Fuji Seisaku-sho, Japan), using as an abrasive material an alundum (crystal alumina obtained from molten bauxite) having a grain size of # 200 according to Japanese Industrial Standards R6001. The sandblasting was effected for 30 seconds under a pneumatic pressure of 3 bar (kg/cm²).

The thus engraved glass plate was immersed in a mixed solvent (1,1,1-trichloro ethane: isopropyl alcohol=70:30 (by volume)] and shaken for 20 seconds, thereby to swell the photopolymerized pattern layer remaining on the glass plate so that the photopolymerized pattern layer was removed. Thus, fine patterns were engraved on the glass plate.

In this Example, the photopolymerized pattern layer had a Shore Durometer hardness A of 50, a tensile strength of 7840 KPa (80 kg/cm²) and an elongation of 100%.

Example 2

200 Parts by weight of polypropylene glycol having a number average molecular weight of about 2,000 was mixed with 26 parts by weight of tolylene diisocyanate and 0.5 part by weight of dibutyltin dilaurate, and reaction was effected at 70°C for 2 hours to obtain a urethane prepolymer having isocyanate groups at both ends thereof. Then, 15 parts by weight of 2-hydroxypropyl methacrylate and 0.025 part by weight of 2,6-di-tert-butyl-p-cresol were added to the thus obtained urethane prepolymer, and reaction was effected at 70°C for 2 hours to obtain an unsaturated urethane prepolymer.

100 Parts by weight of the thus obtained unsaturated urethane prepolymer was mixed with 35 parts by weight of 2-hydroxypropyl methacrylate, 3.0 parts by weight of 2,2-dimethoxyphenyl acetophenone, 0.5 part of weight of silicone KP-324 (trademark of a silicone type anti-foam agent manufactured and sold by Shin-Etsu Chemical Co., Ltd., Japan) and 0.5 part by weight of phthalocyanine green to obtain a photopolymerizable composition having a viscosity of 15 Pa.s (150 P) (as measured at 25°C).

The thus obtained photopolymerizable composition was applied to a glass plate (20 cm×30 cm×10 mm) at room temperature using a stainless steel screen bearing an image and having an emulsion thickness of 20 µm, which screen had been prepared by applying a diazo type photosensitive emulsion comprising a diazo resin and a polyvinyl alcohol to a stainless steel screen having 200 meshes per 2.54 cm (200 mesh, Tyler) and subjected to image forming treatment by photomechanical technique. As a result, a pattern layer of the photopolymerizable composition corresponding to the image borne by the screen and having a thickness of 100 µm was formed on the glass plate. The pattern-formed glass plate was exposed to actinic radiation in substantially the same manner as in Example 1.

Subsequently, the thus obtained pattern-formed glass plate was sandblasted by means of a siphon-type sandblaster (manufactured and sold by Fuji Seisaku-sho, Japan), using as an abrasive material an alundum (crystal alumina obtained from molten bauxite) having a grain size of # 200 according to Japanese Industrial Standards R6001. The sandblasting was effected for 30 seconds under a pneumatic pressure of 3 bar (kg/cm²). The photopolymerized pattern layer remaining on the glass plate was removed in substantially the same manner as in Example 1.

In this Example, the photopolymerized pattern layer had a Shore Durometer hardness A of 60, a tensile strength of 9810 KPa (100 kg/cm²) and an elongation of 80%.

Example 3

100 Parts by weight of liquid polybutadiene (number average molecular weight: about 1,500) having hydroxyl groups at both ends thereof was mixed with 13 parts by weight of tolylene dissocyanate (a mixture of 80% of weight of 2,4-isomer and 20% by weight of 2,6-isomer) and 0.25 part by weight of dibutyltin dilaurate, and reaction was effected at 70°C for 2 hours to form a urethane prepolymer having isocyanate groups at both ends thereof. Then, 10 parts by weight of 2-hydroxyethyl methacrylate and 0.025 part by weight of 2,6-di-tert-butyl-p-cresol were added to the thus obtained urethane prepolymer, and reaction was effected at 70°C for 2 hours to obtain an unsaturated urethane prepolymer.

100 Parts by weight of the thus obtained unsaturated urethane prepolymer was mixed with 50 parts by weight of 2-hydroxyethyl methacrylate, 50 parts by weight of mono-(2-hydroxyethyl methacryl) phthalate, 40 parts by weight of 2,2-dimethoxyphenyl acetophenone, 2 parts by weight of Disparlon #1970 (trademark of a leveling agent manufactured and sold by Kusumoto Chemicals Ltd., Japan) and 0.3 part by weight of phthalocyanine green to obtain a photopolymerizable composition having a viscosity of 70 Pa.s (700 P) (as measured at 25°C).

The thus obtained photopolymerizable composition was applied to a glass container at room temperature using a stainless steel screen bearing an image and having an emulsion thickness of 20 μm, which screen had been prepared by applying a diazo type photosensitive emulsion comprising a diazo resin and a polyvinyl alcohol to a stainless steel screen having 200 meshes per 2.54 cm (200 mesh, Tyler) and subjected to image forming treatment by photomechanical technique.

As a result, a pattern layer of the photopolymerizable composition corresponding to the image borne by the screen and having a thickness of 100 μm was formed on the glass container. The photopolymerizable composition pattern layer-formed glass container was passed at a rate of 4 m/min under an actinic radiation device having three metal halide high pressure mercury lamps (each 120 W/cm) by means of a conveyor placed at a distance of 1 m from the device so that the pattern-formed glass container was exposed to actinic radiation for photopolymerization.

Subsequently, the thus obtained pattern-formed glass container was sandblasted by means of a siphon-type sandblaster (manufactured and sold by Fuji Seisaku-sho, Japan), using as an abrasive material an alundum (crystal alumina obtained from molten bauxite) having a grain size of #200 according to Japanese Industrial Standards R6001. The sandblasting was effected for 30 seconds under a pneumatic pressure of 3 bar (kg/cm²). The thus engraved glass container was immersed in a mixture of 50 parts by volume of hydrofluoric acid and 50 parts by volume of concentrated sulfuric acid at room temperature for one minute, followed by washing with water. Then, the glass container was immersed in a 5% by weight aqueous NaOH solution and brushed with a nylon brush to remove the layer from the glass container. Thus, a transparent glass container having an engraved pattern was obtained.

In this Example, the photopolymerized layer had a Shore Durometer hardness A of 90, a tensile strength of 2943 N/cm² (300 kg/cm²) and an elongation of 50%. The photopolymerized pattern layer showed a good resistance to the mixture of hydrofluoric acid and concentrated sulfuric acid.

### Example 4

100 Parts by weight of liquid polybutadiene (number average molecular weight: about 1500) having hydroxyl groups at both ends thereof was mixed with 13 parts by weight of tolylene diisocyanate (a mixture of 80% by weight of 2,4-isomer and 20% by weight of 2,6-isomer) and 0.25 part by weight of dibutyltin dilaurate, and reaction was effected at 70°C for 2 hours to form a urethane prepolymer having isocyanate groups at both ends thereof. Then, 10 parts by weight of 2-hydroxyethyl methacrylate and 0.025 part by weight of 2,6-di-tert-butyl-p-cresol were added to the thus obtained urethane prepolymer, and reaction was effected at 70°C for 2 hours to obtain an unsaturated urethane prepolymer.

100 Parts by weight of the thus obtained unsaturated urethane prepolymer was mixed with 48 parts by weight of 2-hydroxyethyl methacrylate, 2 parts by weight of monomethacryloxyethyl phosphate, 50 parts by weight of mono(2-hydroxyethyl methacryl) phthalate, 4 parts by weight of 2,2-dimethoxyphenyl acetophenone, 2 parts by weight of Disparlon #1970 (trademark of a leveling agent manufactured and sold by Kusumoto Chemicals Ltd., Japan) and 0.3 part by weight of phthalocyanine green to obtain a photopolymerizable composition having a viscosity of 70 Pa.s (700 P) (as measured at 25°C).

The thus obtained photopolymerizable composition was applied, at room temperature, to a copper-clad board comprising a 18 μm-thick copper foil and phenol resin-impregnated paper board which had been prepared by pressing under heating, using a stainless steel screen bearing a circuit pattern and having an emulsion thickness of 20 μm, which screen had been prepared by applying a diazo type photosensitive emulsion comprising a diazo resin and a polyvinyl alcohol to a stainless steel screen having 200 meshes per 2.54 cm (200 mesh, Tyler) and subjected to image forming treatment by photomechanical technique. As a result, a pattern layer of the photopolymerizable composition having a thickness of 100 μm and corresponding to the circuit pattern borne by the screen was formed on the copper-clad board. The photopolymerizable composition pattern layer-formed board was passed at a rate of 4 m/min under an actinic radiation device having three metal halide high pressure mercury lamps (each 120 W/cm) by means of a conveyor placed at a distance of 1 m from the device so that the photopolymerizable composition pattern layer-formed surface of the board was completely exposed to actinic radiation for photopolymerization.

Subsequently, the thus obtained pattern-formed board was sandblasted by means of a siphon-type sandblaster (manufactured and sold by Fuji Seisaku-sho, Japan), using as an abrasive material an alundum (crystal alumina obtained from molten bauxite) having a grain size of #200 according to Japanese Industrial Standards R6001. The sandblasting was effected for 60 seconds under a pneumatic pressure of 3 bar (kg/cm$^2$). The thus engraved board was immersed in a mixture of 1 part by volume of a 35% by weight aqueous hydrochloric acid solution and 1 part by volume of a 200 g/liter aqueous copper (II) chloride solution at room temperature for one minute so that the copper which was not covered with the photopolymerized pattern layer and which remained at the engraved portions was completely removed, followed by washing with water. Then, the board was immersed in a 5% by weight aqueous NaOH solution and brushed with a nylon brush to remove the photopolymerized pattern layer from the board. Thus, a pattern circuit was formed on the board.

In this Example, the photopolymerized pattern layer had a Shore Durometer hardness A of 90, a tensile strength of 29430 KPa (300 kg/cm$^2$) and an elongation of 50%.

## Example 5

100 Parts by weight of a copolymer of ethylene oxidepropylene oxide having two hydroxyl groups at both ends thereof (the content of ethylene oxide) 35% by weight, number average molecular weight: about 2,000) was mixed with 100 parts by weight of polyethylene glycol adipate diol (having a number average molecular weight of 2,000), 26 parts by weight of tolylene diisocyanate and 0.5 part by weight of dibutyltin dilaurate, and reaction was effected at 70°C for 2 hours to obtain an intermediate product having isocyanate groups at both ends thereof. Then, to the obtained intermediate product were added 15 parts by weight of 2-hydroxylethyl methacrylate and 0.025 part by weight of 2,6-di-tert-butyl-p-cresol, and reaction was effected at 70°C for 2 hours to obtain an unsaturated urethane prepolymer.

100 Parts by weight of the thus obtained unsaturated urethane prepolymer was mixed with 50 parts by weight of 2-hydroxylethyl methacrylate, 50 parts by weight mono-(2-hydroxylethyl methacryl) phthalate, 4 parts by weight of 2,2-dimethyoxyphenyl acetophenone, 0.4 part by weight of Silicone KP-324 (trademark of a silicone type anti-foam agent manufactured and sold by Shin-Etsu Chemical Co., Ltd., Japan) and 0.3 part by weight of phthalocyanine green to obtain a photopolymerized composition having a viscosity of 70 Pa.s (700 P) (as measured at 25°C).

The thus obtained photopolymerizable composition was applied to a glass plate (20 cm×30 cm×10 mm) using a stainless steel screen bearing an image and having an emulsion thickness of 20 µm, which screen had been prepared by applying a diazo type photosensitive emulsion comprising a diazo resin and a polyvinyl alcohol to a stainless steel screen having 200 meshes per 2.54 cm (200 mesh, Tyler) and subjected to image forming treatment by photomechanical technique. As a result, a pattern layer of the photopolymerizable composition corresponding to the image borne by the screen and having a thickness of 100 µm was formed on the glass plate. The photopolymerizable composition pattern layer-formed glass plate was passed at a rate of 4 m/min under an actinic radiation device having three metal halide high pressure mercury lamps (each 120 W/cm) by means of a conveyor placed at a distance of 1 m from the device so that the pattern-formed surface of glass plate was exposed to actinic radiation for photopolymerization.

Subsequently, the thus obtained pattern-formed glass plate was sandblasted through the pattern layer by means of a siphon-type sandblaster (manufactured and sold by Fuji Seisaku-sho, Japan), using as an abrasive material an alundum (crystal alumina obtained from molten bauxite) having a grain size of #200 according to Japanese Industrial Standards R6001. The sandblasting was effected for 30 seconds under a pneumatic pressure of 3 bar (kg/cm$^2$).

The thus obtained glass plate was immersed and shaken in a 5% by weight aqueuos NaOH solution at room temperature to remove the remaining pattern layer from the glass plate. Thus, an engraved fine pattern having strips with a width of 300 µm was obtained on the glass plate.

In this Example, the photopolymerized layer had a Shore Durometer hardness A of 85, a tensile strength of 24530 KPa (250 kg/cm$^2$) and an elongation of 100%.

## Example 6

A photopolymerizable composition was prepared in substantially the same manner as described in Example 5 except that in place of 50 parts by weight of mono(2-hydroxyethyl methacryl) phthalate, 50 parts by weight of monomethacryloxyethyl phosphate. The thus prepared photopolymerizable comopsition had a viscosity of 50 Pa.s (500 P) (as measured at 25°C).

The thus obtained photopolymerizable composition was applied to a glass plate (20 cm×30 cm×10 mm) at room temperature using a stainless steel screen having 200 meshes per 2.54 cm (200 mesh, Tyler) bearing an image and having an emulsion thickness of 20 µm, which screen had been prepared by applying a diazo type photosensitive emulsion comprising a diazo resin and a polyvinyl alcohol to a stainless steel screen (200 mesh, Tyler) and subjected to image forming treatment by photomechanical technique. As a result, a pattern layer of the photopolymerizable composition corresponding to the image borne by the screen and having a thickness of 100 µm was formed on the glass plate. The photopolymerizable composition pattern layer-formed glass plate was passed at a rate of 4 m/min under an actinic radiation device having three metal halide high pressure mercury lamps (each 120 W/cm) by means of a conveyor placed at a distance of 1 m from the device so that the photopolymerizable composition pattern layer-formed surface of glass plate was exposed to actinic radiation for photopolymerization. Subsequently, the thus obtained pattern-formed glass plate was sandblasted

13

through the pattern layer by means of a siphon-type sandblaster (manufactured and sold by Fuji Seisaku-sho, Japan), using as an abrasive material an alundum (crystal alumina obtained from molten bauxite) having a grain size of #200 according to Japanese Industrial Standards R6001. The sandblasting was effected for 30 seconds under a pneumatic pressure of 3 bar (3 kg/cm²).

The thus obtained glass plate was immersed and shaken in a 5% by weight aqueous NaOH solution at room temperature to remove the remaining pattern layer from the glass plate. Thus, an engraved fine pattern having strips with a width of 300 µm was engraved on the glass plate.

In this Example the photopolymerized layer had a Shore Durometer hardness A of 80, a tensile strength of 19620 KPa (200 kg/cm²) and an elongation of 60%.

Example 7

100 Parts by weight of a copolymer of ethylene oxidepropylene oxide having two hydroxyl groups at both ends thereof (the content of ethylene oxide) 35% by weight, number average molecular weight: about 2,000) was mixed with 100 parts by weight of polyethylene glycol adipate diol (having a number average molecular weight of 2,000), 26 parts by weight of tolylene diisocyanate and 0.5 part by weight of dibutyltin dilaurate, and reaction was effected at 70°C for 2 hours to obtain an intermediate product having isocyanate groups at both ends thereof. Then, to the obtained intermediate product were added 15 parts by weight of 2-hydroxylethyl methacrylate and 0.025 part by weight of 2,6-di-tert-butyl-p-cresol, and reaction was effected at 70°C for 2 hours to obtain an unsaturated urethane prepolymer.

100 Parts by weight of the thus obtained unsaturated urethane prepolymer was mixed with 50 parts by weight of 2-hydroxylethyl methacrylate, 50 parts by weight of mono(2-hydroxylethyl methacryl) phthalate, 3.0 parts by weight of 2,2-dimethoxyphenyl acetophenone, 2 parts by weight of Disparlon #1970 (trademark of a leveling agent manufactured and sold by Kusumoto Chemicals Ltd., Japan) and 0.3 part by weight of phthalocyanine green to obtain photopolymerizable composition having a viscosity of 70 Pa.s (700 P) (as measured at 25°C).

Using three kinds of polyester screens having 300 meshes per 2.54 cm (300 mesh, Tyler) each having an emulsion thickness of 10 µm and respectively bearing the desired different images, a finished pattern layer which has a predetermined three dimensional pattern structure and of which the polymeric image portions have a thickness varied in accordance with the predetermined three dimensional pattern structure in accordance with the following procedures.

First, the above-obtained photopolymerizable composition was applied to a glass plate (20 cm×30 cm×10 mm) at room temperature, using a first polyester screen having 300 meshes per 2.54 cm) (300 mesh, Tyler) bearing a first image and having an emulsion thickness of 10 µm so that a preliminary pattern layer was formed on the glass plate. Then, the photopolymerizable composition pattern layer-formed glass plate was passed at a rate of 6 m/min under an actinic radiation device having three metal halide high pressure mercury lamps (each 120 W/cm) by means of a conveyor placed at a distance of 1 m from the device so that the photopolymerizable composition pattern layer-formed glass plate was exposed to actinic radiation for photopolymerization, thereby to form a pattern layer constituted by vacant image portions and polymeric image portions. Then, using a second polyester screen having 300 meshes per 2.54 cm (300 mesh, Tyler) bearing a second image and having an emulsion thickness of 10 µm, the above-obtained photopolymerizable composition was applied again onto the pattern-formed surface of the glass plate and substantially the same light exposure operation as mentioned above was conducted. Further, using the second screen, a sequence of the application of the photopolymerizable composition and the light exposure operation was repeated to form another pattern layer constituted by vacant image portions and polymeric image portions having a thickness which is twice that formed using the first polyester screen. Subsequently, using a third polyester screen having 300 meshes per 2.54 cm (300 mesh, Tyler) bearing a third image and having an emulsion thickness of 10 µm, the above obtained photopolymerizable composition was applied again onto the thus prepared pattern-formed surface of the glass plate and substantially the same light exposure operation as mentioned above was conducted. Further, a sequence of the application of the photopolymerizable composition using the third screen and the light exposure operation was repeated three times to obtain still another pattern constituted by vacant image portions and polymeric image portions having a thickness which is four-fold that formed using the first polyester screen. The thickness of the pattern layer formed using the first screen, that formed using the second screen and that formed using the third screen were 20 µm, 40 µm, and 80 µm, respectively.

Subsequently, sandblasting was effected against the thus obtained pattern-formed glass plate over the thus obtained finished pattern of which the polymeric image portions have a thickness varied in accordance with the predetermined three dimensional pattern structure by means of a siphon-type sandblaster (manufactured and sold by Fuji Seisaku-sho, Japan), using as an abrasive material an alundum (crystal alumina obtained from molten bauxite) having a grain size of #200 according to Japanese Industrial Standards R6001. The sandblasting was effected for 60 seconds under a pneumatic pressure of 3 bar (kg/cm²).

The thus obtained glass plate was immersed and shaken in a 5% by weight aqueous NaOH solution to remove the remaining pattern layer from the glass plate. Thus, fine patterns of which the carved portions were varied with respect to depth were obtained on the glass plate. The surface portions of the glass plate corresponding to the polymeric image portions having a thickness of 80 μm was not engraved and those corresponding to the polymeric image portions having a thickness of 40 μm was coarsened and became opaque. The surface portions of the glass plate corresponding to the polymeric image portions having a thickness of 20 μm was engraved in a depth smaller than that of the surface portions corresponding to the vacant image portions.

In this Example, the polymeric image portions of the finished pattern layer had a Shore Durometer hardness A of 85, a tensile strength of 19620 KPa (200 kg/cm$^2$) and an elongation of 100%.

Example 8

Using three kinds of screens, namely a polyester screen having 300 meshes per 2.54 cm (300 mesh, Tyler) having an emulsion thickness of 10 μm and bearing an image, a polyester screen having 200 meshes per 2.54 cm (200 mesh, Tyler) having an emulsion thickness of 30 μm and bearing another image and a stainless steel screen having 200 meshes per 2.54 cm (200 mesh, Tyler) having an emulsion thickness of 20 μm and bearing still another image, a finished pattern layer which had a predetermined three dimensional pattern structure and of which the polymeric image portions had a thickness varied in accordance with the predetermined three dimensional pattern structure was obtained in accordance with the following procedures.

First, the photopolymerizable composition prepared in Example 7 was applied to a glass plate (20 cm×30 cm×10 mm) at room temperature using a first polyester screen having 300 meshes per 2.54 cm (300 mesh, Tyler) bearing a first image and having an emulsion thickness of 10 μm so that a preliminary pattern layer was formed on the glass plate. Then, the photopolymerizable composition pattern layer-formed glass plate was passed at a rate of 6 m/min under an actinic radiation device having three metal halide high pressure mercury lamps (each 120 W/cm) by means of a conveyor placed at a distance of 1 m from the device so that the photopolymerizable composition pattern layer-formed glass plate was exposed to actinic radiation for photopolymerization, thereby to form a pattern layer constituted by vacant image portions and polymeric image portions. Then, using a second polyester screen having 200 meshes per 2.54 cm (200 mesh, Tyler) bearing a second image and having an emulsion thickness of 30 μm, the photopolymerizable composition was applied again onto the pattern-formed surface of the glass plate and substantially the same light exposure operation as mentioned above was conducted to form a second pattern layer constituted by vacant image portions and polymeric image portions having a thickness wihch is different from that formed using the first polyester screen. Subsequently, using a stainless steel screen having 200 meshes per 2.54 cm (200 mesh, Tyler) bearing a third image and having an emulsion thickness of 20 μm, the photopolymerizable composition was applied again onto the thus prepared pattern-formed surface of the glass plate and substantially the same light exposure operation as mentioned above was conducted to form a third pattern layer constituted by vacant image portions and polymeric image portions having a thickness which is different from that formed using the first polyester screen and that formed using the second polyester screen. The thickness of the pattern layer formed using the first polyester screen, that formed using the second polyester screen and that formed using the stainless steel screen were 20 μm, 50 μm and 100 μm, respectively.

Subsequently, sandblasting was effected against the thus obtained pattern-formed glass plate over the pattern layer of which the thickness was changed in accordance with the predetermined three dimensional pattern structure by means of a siphon-type sandblaster (manufactured and sold by Fuji Seisaku-sho, Japan), using as an abrasive material an alundum (crystal alumina obtained from molten bauxite) having a grain size of #200 according to Japanese Industrial Standards R6001. The sandblasting was effected for 60 seconds under a pneumatic pressure of 3 bar (kg/cm$^2$).

The thus obtained glass plate was immersed and shaken in a 5% by weight aqueous NaOH solution to remove the pattern layer from the glass plate. Thus, a fine pattern of which the carved portions were varied with respect to depth was obtained on the glass plate. The surface portions of the glass plate corresponding to the polymeric image portions having a thickness of 100 μm was not engraved and those corresponding to the polymeric portions having a thickness of 50 μm was like ground glass. The surface portions of the glass plate corresponding to the polymeric image portions having a thickness of 20 μm was engraved in a depth smaller than that of the surface portions corresponding to the vacant image portions.

In this Example, the polymeric image portions of the finished pattern layer had a Shore Durometer hardness A of 85, a tensile strength of 19620 KPa (200 kg/cm$^2$) and an elongation of 100%.

**Claims**

1. A method for producing a pattern-engraved article by sandblasting which comprises the steps of:

(1) image-wise applying a photopolymerizable composition onto the surface of an article body by a screen printing method to form a preliminary predetermined pattern layer constituted by vacant image portions and polymerizable composition image portions, said photopolymerizable composition comprising:

(a) a urethane prepolymer having acrylate groups or methacrylate groups,

(b) an ethylenically unsaturated monomer, and

(c) a photopolymerization initiator,

(2) subjecting the preliminary pattern layer on the article body to photopolymerization treatment to convert the polymerizable composition image portions to polymeric image portions having a Shore Durometer hardness A of 90 or less, a tensile strength of 4900 to 39200 kPa (50 to 400 kg/cm²), and an elongation of 30 to 400%;

the steps (1) and (2), in combination, being performed at least one time, thereby to form on the surface of the article body a finished pattern layer having a predetermined three dimensional pattern structure and constituted by the resulting vacant image portions and the resulting polymeric image portions;

(3) blowing an abrasive material against the article body on its surface having the finished pattern layer to engrave at least an image corresponding to said resulting vacant image portions of the finished pattern layer on the article body; and

(4) removing the remaining polymeric image portions from the finished pattern layer.

2. A method according to claim 1, wherein said steps (1) and (2), in combination, are performed at least one time so that the resulting polymeric image portions of the finished pattern layer have a thickness substantially equal with respect to all the polymeric image portions, and in step (3), the blowing of an abrasive material is performed through said resulting vacant image portions against the article body to engrave an image corresponding to that of said resulting vacant image portions on the article body.

3. A method according to claim 1, wherein said steps (1) and (2), in combination, are performed a plurality of times so that the resulting polymeric image portions of the finished pattern layer have a thickness varied in accordance with the predetermined three dimensional pattern structure, and in step (3), the blowing of an abrasive material is performed so that not only surface portions of the article body corresponding to said resulting vacant image portions but also surface portions of the article body corresponding to said resulting polymeric image portions at their portions having a relatively small thickness are engraved to form on the article body an engraved pattern of which the engraved portions have a depth varied in accordance with the predetermined three dimensional pattern structure.

4. A method according to claim 3, wherein the polymeric image portions obtained by at least one sequence of said steps (1) and (2) are at least partially different in pattern from those obtained by the preceding and/or subsequent sequence of said steps (1) and (2).

5. A method according to claim 1, wherein in step (1), the image-wise application of a photopolymerizable composition is performed so that the photopolymerizable composition image portions of said preliminary pattern layer have a thickness varied in accordance with a preliminary predetermined three dimensional pattern, and in step (3), the blowing of an abrasive material is performed so that not only surface portions of the article body corresponding to said resulting vacant image portions but also surface portions of the article body corresponding to said resulting polymeric image portions at their portions having a relatively small thickness are engraved to form on the article body an engraved pattern of which the engraved portions have a depth varied in accordance with the predetermined three dimensional pattern structure.

6. A method according to any of claims 1 to 5, wherein the photopolymerizable composition further comprises:

(d) a heat polymerization inhibitor and

(e) an anti-foam agent and/or a leveling agent.

**Patentansprüche**

1. Verfahren zur Herstellung eines mit Gravurmuster versehenen Gegenstandes durch Sandstrahlen, welches folgende Stufen umfaßt:

(1) bildmäßiges Auftragen einer photopolymerisierbaren Zusammensetzung auf die Oberfläche des Körpers eines Gegenstandes mit Hilfe eines Siebdruckverfahrens unter Ausbildung einer vorläufigen vorbestimmten Musterschicht, die aus leeren Bildbereichen und aus der polymerisierbaren Zusammensetzung bestehenden Bildbereichen aufgebaut ist, wobei die photopolymerisierbare Zusammensetzung

(a) ein Urethan-Präpolymeres mit Acrylatgruppen oder Methacrylatgruppen,

(b) ein ethylenisch ungesättigtes Monomeres und

(c) einen Photopolymerisationsinitiator umfaßt,

(2) Anwenden einer Photopolymerisationsbehandlung auf die vorläufige Musterschicht auf dem Körper des Gegenstandes, um die aus der polymerisierbaren Zusammensetzung bestehenden Bildbereiche in polymere Bildbereiche mit einer Shore-Durometer-Härte A von 90 oder weniger, einer Zugfestigkeit von 4900 bis 39 200 kPa (50 bis 400 kg/cm²) und einer Dehnung von 30 bis 400% umzuwandeln,

wobei die Stufen (1) und (2) in Kombination mindestens einmal durchgeführt werden, so daß auf der Oberfläche des Körpers des Gegenstandes eine fertige Musterschicht mit einer vorbestimmten dreidimensionalen Musterstruktur ausgebildet wird, die aus den resultierenden leeren Bildbereichen und den resultierenden polymeren Bildbereichen aufgebaut ist;

(3) Blasen eines Schleifmaterials gegen den Körper des Gegenstandes, der auf seiner Oberfläche die fertige Musterschicht hat, um mindestens ein Bild zu gravieren, das den resultierenden leeren Bildbereichen der fertigen Musterschicht auf dem Körper des Gegenstandes entspricht und

(4) Entfernen der verbleibenden polymeren Bildbereiche von der fertigen Musterschicht.

2. Verfahren gemäß Anspruch 1, bei dem die Stufen (1) und (2) in Kombination mindestens einmal durchgeführt werden, so daß die resultierenden polymeren Bildbereiche der fertigen Musterschicht eine Dicke haben, die im wesentlichen gleich im Hinblick auf alle polymeren Bildbereiche ist, und in Stufe (3) das Blasen eines Schleifmaterials durch die resultierenden leeren Bildbereiche gegen den Körper des Gegenstandes erfolgt, wobei ein Bild graviert wird, welches dem der resultierenden leeren Bildbereiche auf dem Körper des Gegenstandes entspricht.

3. Verfahren gemäß Anspruch 1, bei dem die Stufen (1) und (2) in Kombination mehrere Male durchgeführt werden, so daß die resultierenden polymeren Bildbereiche der fertigen Musterschicht eine Dicke haben, die in Abhängigkeit von der vorbestimmten dreidimensionalen Musterstruktur variiert ist, und in Stufe (3) das Blasen eines Schleifmaterials so durchgeführt wird, daß nicht nur Oberflächenbereiche des Körpers des Gegenstandes, die den resultierenden leeren Bildbereichen entsprechen, sondern auch Oberflächenbereiche des Körpers des Gegenstandes, die den entstandenen polymeren Bildbereichen in Teilen, die eine relativ geringe Dicke haben, graviert werden, wobei auf dem Körper des Gegenstandes ein Gravurmuster ausgebildet wird, dessen gravierte Teile eine Tiefe besitzen, die in Abhängigkeit von der vorbestimmten dreidimensionalen Musterstruktur variiert ist.

4. Verfahren gemäß Anspruch 3, bei dem die polymeren Bildbereiche, die durch mindestens eine Folge der Stufen (1) und (2) erhalten werden, im Muster mindestens teilweise verschieden von denen sind, die durch die vorhergehende und/oder anschließende Folge dieser Stufen (1) und (2) erhalten werden.

5. Verfahren gemäß Anspruch 1, bei dem in Stufe (1) das bildmäßige Auftragen einer photopolymerisierbaren Zusammensetzung derart durchgeführt wird, daß die Bildbereiche aus der photopolymerisierbaren Zusammensetzung der vorläufigen Musterschicht eine Dicke haben, die in Übereinstimmung mit einem vorläufigen vorbestimmten dreidimensionalen Muster variiert ist, und in Stufe (3) das Blasen des Schleifmaterials so durchgeführt wird, daß nicht nur Oberflächenbereiche des Körpers des Gegenstandes, die den resultierenden leeren Bildbereichen entsprechen, sondern auch Oberflächenbereiche des Körpers des Gegenstandes, die den resultierenden polymeren Bildbereichen entsprechen, in Teilen, die eine relativ kleine Dicke haben, graviert werden, wobei auf dem Körper des Gegenstandes ein Gravurmuster gebildet wird, dessen gravierte Bereiche eine Tiefe haben, die in Übereinstimmung mit der vorbestimmten dreidimensionalen Musterstruktur variiert ist.

6. Verfahren gemäß einem der Ansprüche 1 bis 5, bei dem die photopolymerisierbare Zusammensetzung zusätzlich enthält:

(d) einen Inhibitor für die thermische Polymerisation und

(e) ein Antischaummittel und/oder ein Verlaufmittel.

**Revendications**

1. Procédé de gravure au jet de sable d'un motif sur un objet, qui comprend les stades de:

(1) application de manière à former une image d'une composition photopolymérisable à la surface du corps d'un objet, par un procédé de sérigraphie, pour former une couche préliminaire à motif déterminé à l'avance constitué de parties d'images inoccupées et de parties d'image en la composition polymérisable, cette composition photopolymérisable comprenant

(a) un prépolymère d'uréthanne ayant des groupes acrylate ou des groupes méthacrylate,

(b) un monomère à insaturation éthylénique, et

(c) un initiateur de photopolymérisation,

(2) soumission de la couche préliminaire à motif sur le corps de l'objet à un traitement de photopolymérisation pour transformer les parties d'image en composition photopolymérisable en parties d'image polymères ayant une dureté Shore A de 90 ou inférieure à cette valeur, une résistance à la fraction de 4900 à 39200 kPa (50 à 400 kg/cm$^2$), et un allongement de 30 à 400%;

les stades (1) et (2) en combinaison étant effectués au moins une fois, de manière à former à la surface du corps de l'objet une couche finie à motif ayant une structure de motif tridimensionnelle déterminée à l'avance et constituée des parties d'image inoccupées et des parties d'image polymères qui sont obtenues;

(3) projection d'une matière abrasive sur le corps de l'objet, sur sa surface ayant la couche finie à motif, pour graver au moins une image correspondant aux parties d'image inoccupées de la couche finie à motif sur le corps de l'objet; et

(4) élimination des parties d'image polymères restantes de la couche finie à motif.

2. Procédé suivant la revendication 1, dans lequel les stades (1) et (2) en combinaison sont effectués au moins une fois de manière que les parties d'image polymères obtenues de la couche finie à motif aient une épaisseur sensiblement égale, pour toutes les parties d'image polymères et, au stade (3), la projection d'une matière abrasive est effectuée à travers les parties d'image inoccupées obtenues sur le corps de l'objet, pour graver l'image correspondant à celle des parties d'image inoccupées obtenues sur le corps de l'objet.

3. Procédé suivant la revendication 1, dans lequel les stades (1) et (2) en combinaison sont effectués plusieurs fois, de manière que les parties d'image polymères obtenues de la couche finie à motif aient une épaisseur qui varie en fonction de la structure déterminée à l'avance du motif à trois dimensions et, au stade (3), la projection d'une matière abrasive est effectuée de manière à graver non seulement des parties de surface du corps de l'objet correspondant aux parties d'image inoccupées obtenues, mais également des parties de surface du corps de l'objet correspondant aux parties d'image polymères obtenues, en leurs parties ayant une épaisseur relativement petite pour former, sur le corps de l'objet, un motif gravé dont les parties gravées ont une épaisseur qui varie suivant la structure de motif tridimensionnelle déterminée à l'avance.

4. Procédé suivant la revendication 3, dans lequel les parties d'image polymères obtenues par au moins une séquence des stades (1) et (2) diffèrent au moins partiellement par leurs motifs de celles obtenues par la séquence précédente et/ou suivante des stades (1) et (2).

5. Procédé suivant la revendication 1, dans lequel, au stade (1), l'application de manière à former une image d'une composition photopolymérisable est effectuée de manière que les parties d'image en la composition photopolymérisable de la couche préliminaire à motif ait une épaisseur qui varie en fonction d'un motif préliminaire tridimensionnel déterminé à l'avance et, au stade (3), la projection d'une matière abrasive est effectuée de manière à graver non seulement des parties de surface du corps de l'objet correspondant aux parties d'image inoccupées obtenues, mais aussi des parties de surface du corps de l'objet correspondant aux parties d'image polymères obtenues en leurs parties ayant une épaisseur relativement petite, pour former sur le corps de l'objet un motif gravé dont les parties gravées ont une profondeur qui varie en fonction de la structure de motif tridimensionnel déterminée à l'avance.

6. Procédé suivant l'une quelconque des revendications 1 à 5, dans lequel la composition photopolymérisable comprend, en outre:

(d) un inhibiteur de polymérisation sous l'effet de la chaleur, et

(e) un agent anti-mousse et/ou un agent nivelant.

FIG. 1

FIG. 2

FIG. 3

F I G. 4

F I G. 5